# EUROPÄISCHE PATENTSCHRIFT

(11) **EP 4 584 826 B1**
(45) Veröffentlichungstag und Bekanntmachung des Hinweises auf die Patenterteilung: **10.12.2025**
(21) Anmeldenummer: 24826954.0
(22) Anmeldetag: 26.11.2024
(51) Int. Cl.: H01M 8/04664

(54) **VERFAHREN ZUR ERKENNUNG EINES ELEKTRISCHEN KURZSCHLUSSES AN EINEM BRENNSTOFFZELLENSTAPEL EINES BRENNSTOFFZELLENSYSTEMS**
METHOD FOR DETECTING AN ELECTRIC SHORT CIRCUIT IN A FUEL CELL SYSTEM AND FUEL CELL SYSTEM
PROCÉDÉ DE DETECTION D'UN COURT-CIRCUIT DANS UN SYSTÈME DE PILE À COMBUSTIBLE ET SYSTÈME DE PILE À COMBUSTIBLE

(30) Priorität: 27.11.2023 AT 509512023
(43) Veröffentlichungstag der Anmeldung: 16.07.2025
(73) Patentinhaber: AVL List GmbH, 8020 Steiermark Graz (AT)
(72) Erfinder: RAMMER, Georg, 8047 Graz (AT); WEINGRILL, David, 8152 Stallhofen (AT)
(86) Internationale Anmeldenummer: PCT/AT2024/060463
(87) Internationale Veröffentlichungsnummer: WO 2025/111626

(56) Entgegenhaltungen:
- US-A1- 2020 328 439

## Beschreibung

Die vorliegende Erfindung betrifft ein Verfahren zur Erkennung eines elektrischen Kurzschlusses an einem Brennstoffzellenstapel eines Brennstoffzellensystems, ein Computerprogrammprodukt zur Durchführung eines solchen Verfahrens, eine Erkennungsvorrichtung zur Durchführung eines solchen Verfahrens sowie ein Brennstoffzellensystem mit einer solchen Erkennungsvorrichtung.

Es ist bekannt, dass bei Brennstoffzellensystemen im Betrieb verschiedene Fehlerfälle mit hoher Sicherheit erkannt werden können. Ein solcher Fehlerfall ist ein elektrischer Kurzschluss, welcher zum Beispiel durch mechanische Beeinflussung, Verschleiß oder auch Fehlmontage entstehen kann. Um einen elektrischen Kurzschluss zu erkennen und möglicherweise entsprechende Sicherungsmaßnahmen oder Gegenmaßnahmen zu ergreifen, ist bei den bisherigen Lösungen eine Überwachung der Zellspannung des Brennstoffzellenstapels notwendig. Mit anderen Worten ist eine solche Zellspannungsüberwachung mit einzelnen Zellspannungssensoren ausgestattet, welche es erlauben, die Spannung an einem oder mehreren Teilen des Brennstoffzellenstapels abzugreifen, zu überwachen und mit entsprechenden Zellspannungsgrenzwerten zu vergleichen.

Ein entscheidender Nachteil der bekannten Lösungen ist es, dass für die Überwachung der Zellspannung entsprechend dafür spezifische Zellspannungssensoren verbaut sein müssen. Dies erhöht den Platzbedarf und die Komplexität des gesamten Brennstoffzellensystems wie auch dessen Kosten, da eine Vielzahl solcher einzelner Sensoren mit entsprechenden Kommunikationsverbindungen eingebaut werden müssen. US 2020/328439 offenbart ein Verfahren zur Erkennung eines elektrischen Kurzschlusses an einem Brennstoffzellenstapel bei dem durch Messung einer Leerlaufspannung auf einen Kurzschluss geschlossen wird.

Es ist Aufgabe der vorliegenden Erfindung, die voranstehend beschriebenen Nachteile zumindest teilweise zu beheben. Insbesondere ist es Aufgabe der vorliegenden Erfindung, in kostengünstiger und einfacher Weise eine Kurzschlusserkennung an einem Brennstoffzellenstapel durchführen zu können.

Die voranstehende Aufgabe wird gelöst durch ein Verfahren mit den Merkmalen des Anspruchs 1, ein Computerprogrammprodukt mit den Merkmalen des Anspruchs 12, eine Erkennungsvorrichtung mit den Merkmalen des Anspruchs 13 und ein Brennstoffzellensystem mit den Merkmalen des Anspruchs 14. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Computerprogrammprodukt, der erfindungsgemäßen Erkennungsvorrichtung sowie dem erfindungsgemäßen Brennstoffzellensystem und jeweils umgekehrt, sodass bezüglich der Offenbarung zu den einzelnen Erfindungsaspekten stets wechselseitig Bezug genommen wird beziehungsweise werden kann.

Erfindungsgemäß soll ein Verfahren durchgeführt werden zur Erkennung eines elektrischen Kurzschlusses an einem Brennstoffzellenstapel eines Brennstoffzellensystems. Ein solches Verfahren zeichnet sich durch die folgenden Schritte aus:
- Überwachen wenigstens eines Gasdrucks im Brennstoffzellensystem,
- Vergleich des überwachten Gasdrucks mit wenigstens einem Druckgrenzwert auf einem Druckabfall,
- Erzeugen eines Kurzschluss-Fehlersignals, wenn der überwachte Gasdruck den wenigstens einen Druckgrenzwert unterschreitet.

Der Kerngedanke der vorliegenden Erfindung liegt darin, dass eine Kurzschlusserkennung unabhängig von einer Zellspannungsüberwachung durchgeführt werden soll. Hierfür wird ein physikalischer Zusammenhang genutzt, welcher im Betrieb des Brennstoffzellensystems im Kurzschlussfall eine Auswirkung auf Gasdrücke mit sich bringt. Entsteht bei einem Brennstoffzellensystem ein elektrischer Kurzschluss, so führt dies in sehr kurzer Zeit dazu, dass der hohe Kurzschlussstrom den Brennstoff im Brennstoffzellensystem, insbesondere im Anodenabschnitt, mit höherer Geschwindigkeit verbraucht als dies im regulären Betrieb der Fall ist. Insbesondere wird Brennstoff in der Reaktion, welche für ein Entstehen von Kurzschlussstrom notwendig ist, verbraucht. Durch diesen deutlich beschleunigten Verbrauch ändert sich die Drucksituation und fällt insbesondere wenigstens ein Gasdruck im Brennstoffzellensystem deutlich vom regulären Betriebsdruck ab. Dieser physikalische Hinweis auf die Abweichung vom regulären Betrieb kann nun in erfindungsgemäßer Weise als Auslöser für das Erzeugen des Kurzschluss-Fehlersignals verwendet werden.

Dabei ist es im ersten Schritt unerheblich, welcher tatsächliche Gasdruck im Brennstoffzellensystem überwacht wird. Es kann es um einen oder mehrere Gasdrücke, um Gasdrücke auf der Anodenseite wie auch um Gasdrücke auf der Kathodenseite handeln. Auch ist in einem ersten Schritt unerheblich, um welche Art von Druckgrenzwert es sich handelt. So sind sowohl absolute Druckgrenzwerte als auch Steigungsgrenzwerte für den Druckgrenzwert im Rahmen der vorliegenden Erfindung einsetzbar. Auch Kombinationen unterschiedlicher Gasdrücke und spezifischer und unterschiedlicher Druckgrenzwerte sind selbstverständlich grundsätzlich denkbar.

Dadurch, dass durch den physikalischen Zusammenhang des Druckabfalls mit einem elektrischen Kurzschluss nun eine eineindeutige Zuordnung zwischen dieser physikalischen Messung des Drucks und der elektrischen Sondersituation des elektrischen Kurzschlusses besteht, kann eine eineindeutige Zuordnung und Detektion und damit eine Erkennung des elektrischen Kurzschlusses gegeben werden. Dies beruht jedoch auf bereits bestehenden und für den normalen Betrieb vorhandenen Drucksensoren, welche den normalen Betrieb des Brennstoffzellensystems mit den notwendigen Eingangsparametern für die Betriebskontrolle versorgen. Mit anderen Worten können bei Brennstoffzellensystemen die für den normalen Betrieb bereits notwendigen und vorhandenen Drucksensoren dazu verwendet werden, diese Signale auch hinsichtlich einer Erkennung eines elektrischen Kurzschlusses auszuwerten.

Im Vergleich zu den bekannten Lösungen mit separaten Zellspannungssensoren sind also keine separaten Bauteile notwendig. Auch eine separate Verkabelung oder eine separate Kommunikationsverbindung zu solchen neuen zusätzlichen Zellspannungssensoren ist nicht notwendig. Vielmehr kann auf eine gegebene und vorhandene Peripherie zurückgegriffen werden, wodurch die Komplexität des Brennstoffzellensystems im Vergleich zu den bekannten Lösungen sich vereinfachen lässt. Darüber hinaus kann durch den Verzicht auf separate Sensoren auch der Kostenaufwand für das Zurverfügungstellen eines solchen Brennstoffzellensystems und insbesondere der Erkennungsfunktion des elektrischen Kurzschlusses Einfluss genommen werden. Nicht zuletzt wird es auch möglich durch ein reines Kontrollupdate der Kontrollverfahren von bestehenden Brennstoffzellensystemen ohne Zellspannungsüberwachung auch nachträglich noch eine Überwachung und eine Erkennung eines elektrischen Kurzschlusses als Erkennungsfunktionalität zu implementieren.

In einem erfindungsgemäßen Verfahren wird ein Kurzschluss-Fehlersignal erzeugt. Dieses Kurzschluss-Fehlersignal kann im nachfolgenden Betrieb in unterschiedlichster Weise weiterverwendet werden. So kann das Kurzschluss-Fehlersignal zum Beispiel als reines Alarmsignal ausgegeben werden. Jedoch ist es auch denkbar, dass ein Kurzschluss-Fehlersignal weitere Schutzmaßnahmen oder sogar Gegenmaßnahmen auslöst, bis hin zu einem vollständigen Herunterfahren des Brennstoffzellensystems.

Es kann von Vorteil sein, wenn bei einem erfindungsgemäßen Verfahren der Gasdruck wenigstens einer der folgenden Gase überwacht wird:
- Anodenzuführgas in einem Anodenzuführabschnitt,
- Anodenabgas in einem Anodenabführabschnitt,
- Kathodenzuführgas in einem Kathodenzuführabschnitt,
- Kathodenabgas in einem Kathodenabführabschnitt.

Bei der voranstehenden Aufzählung handelt es sich um eine nicht abschließende Liste. Die genannten Gase, welche für die Überwachung des Gasdrucks insbesondere zur Verfügung stehen, sind dabei vorzugsweise Mediengase, welche auch als Betriebsgase bezeichnet werden. Solche Betriebsgase können unterschieden werden von Hilfsgasen, wie sie beispielsweise für die Belüftung eines Gehäuses des Brennstoffzellensystems, aber auch für möglicherweise andere fluide Medien wie Kühlflüssigkeiten, eingesetzt werden können. Solche Mediengase oder Betriebsgase können vorteilhaft gegebenenfalls den gewünschten physikalischen Zusammenhang zwischen einem massiven Druckabfall und dem elektrischen Kurzschluss mitsichbringen, sodass sie alle zusammen, in beliebiger Kombination, aber auch einzeln, für ein erfindungsgemäßes Verfahren eingesetzt werden können.

Ein weiterer Vorteil kann erzielt werden, wenn bei einem erfindungsgemäßen Verfahren wenigstens zwei Gasdrücke überwacht werden, wobei ein Gasdruck auf der Seite eines Anodenabschnitts und ein Gasdruck auf der Seite eines Kathodenabschnitts des Brennstoffzellensystems überwacht wird. So ist es beispielsweise vorstellbar, dass das Anodenzuführgas und das Kathodenzuführgas gemeinsam der Überwachung zugeführt werden. Auch auf der Abgasseite ist eine solche Überwachung möglich hinsichtlich des Anodenabgases und des Kathodenabgases. Selbstverständlich ist auch eine überkreuzende Überwachung, beispielsweise von Anodenzuführgas und Kathodenabführgas und/oder von Anodenabgas und Kathodenzuführgas grundsätzlich denkbar. Die Überwachung von zwei oder sogar mehr Gasdrücken bringt eine weitere Erhöhung der Genauigkeit und Spezifität des Erkennungsverfahrens mit sich. Insbesondere wird es auf diese Weise möglich, zu unterscheiden, ob ein Druckabfall nur einseitig auf der Anodenseite oder der Kathodenseite oder beidseitig stattfindet. Damit kann insbesondere eine verbesserte Unterscheidung zwischen einer einfachen Leckage auf einer einzigen Seite des Brennstoffzellenstapels und einem erhöhten Verbrauch bei einem elektrischen Kurzschluss, welcher einen Druckabfall insbesondere auf beiden Seiten des Brennstoffzellenstapels mit sich bringt, erfolgen. Diese Erhöhung der Spezifität macht die Erkennung in einem erfindungsgemäßen Verfahren robuster, sodass eine Fehlausgabe von Kurzschluss-Fehlersignalen beispielsweise bei plötzlich auftretenden Leckagen in einem einzelnen Gasabschnitt, mit höherer Wahrscheinlichkeit vermieden wird.

Ebenfalls vorteilhaft ist es darüber hinaus, wenn bei einem erfindungsgemäßen Verfahren für jeden überwachten Gasdruck ein spezifischer Druckgrenzwert für den Vergleich verwendet wird. So sind im Normalbetrieb für unterschiedliche Gase, insbesondere unterschiedliche Betriebsgase, auch unterschiedliche normale Betriebskorridore als Druckwerte erwartbar. Ein spezifischer Druckwert für unterschiedlich überwachte Gasdrücke trägt diesen unterschiedlichen regulären Betriebsbedingungen Rechnung und kann damit dazu dienen, die unterschiedlichen Gasdrücke hinsichtlich der spezifischen Druckgrenzwerte im erfindungsgemäßen Erkennungsverfahren für die Erkennung eines elektrischen Kurzschlusses entsprechend spezifisch auszubilden. Das Kurzschluss-Fehlersignal wird dann nur ausgegeben, wenn die für jeden überwachten Gasdruck der jeweils spezifische Druckgrenzwert unterschritten worden ist.

Ein weiterer Vorteil ist es ebenfalls, wenn bei einem erfindungsgemäßen Verfahren aus den überwachten Gasdrücken die Gasdruckdifferenz bestimmt wird und diese mit dem Druckgrenzwert verglichen wird. Der Vergleich des überwachten Gasdrucks erfolgt hier also in indirekter Weise in Form der Gasdruckdifferenz, sodass sich auch der Druckgrenzwert mit einem entsprechenden Gasdruckdifferenzgrenzwert kombinieren lässt. Ein solcher Kombinationsvergleich erlaubt es, die nachfolgende Regelung und insbesondere den Vergleich mit dem Druckgrenzwert noch einfacher und damit regelungsschneller auszubilden.

Vorteile bringt es weiter mit sich, wenn bei einem erfindungsgemäßen Verfahren der Druckgrenzwert zumindest teilweise als Absolutgrenzwert ausgebildet ist. Damit ist der Druckgrenzwert insbesondere eine definierte Druckschwelle oder Druckgrenze, bei deren Unterschreiten ein Kurzschluss-Fehlersignal ausgelöst wird. Die Geschwindigkeit des Druckabfalls und damit die Steigung bei der Überwachung des Gasdrucks spielt hier keine Rolle. Jedoch ist grundsätzlich ein solcher Absolutgrenzwert auch mit einem Steigungsgrenzwert, wie er im nachfolgenden Absatz beschrieben wird, kombinierbar.

So ist es weiter von Vorteil, wenn bei einem erfindungsgemäßen Verfahren der Druckgrenzwert zumindest teilweise als Steigungsgrenzwert ausgebildet ist. Ein solcher Steigungsgrenzwert ist im Vergleich zu einem Absolutgrenzwert gemäß dem voranstehenden Absatz darauf gerichtet, zu erkennen, mit welcher Geschwindigkeit der Druckabfall stattfindet. Bei sehr steilen Druckabfällen kann also erkannt werden mit welcher Geschwindigkeit die Druckabnahme stattfindet, auch dann, wenn sie nicht unter eine Druckschwelle fällt. Insbesondere dann, wenn eine hohe Regelflexibilität oder Kontrollflexibilität für die Zufuhr des überwachten Gases besteht, kann möglicherweise ein Druckausgleich durch die normale Betriebskontrolle stattfinden, bevor der Druckabfall einen Absolutdruckgrenzwert vollständig unterschreitet. Wird ein Steigungsgrenzwert eingesetzt, so kann dieser eine solche hohe Regeldynamik überwinden und damit auch in einem solchen Fall durch den schnellen Abfall des Gasdrucks in einem elektrischen Kurzschlussfall trotzdem diesen erkennen und das Kurzschluss-Fehlersignal erzeugen. Insbesondere wird auf diese Weise eine Leckage von einem elektrischen Kurzschluss noch einfacher, robuster und vor allem genauer unterscheidbar.

Weitere Vorteile kann es mit sich bringen, wenn bei einem erfindungsgemäßen Verfahren der Druckgrenzwert variabel ausgebildet ist, insbesondere als Absolutgrenzwert vom Umgebungsdruck abhängt. Je nach Betriebssituation können elektrische Kurzschlüsse zu unterschiedlichen Druckänderungen führen. Insbesondere dann, wenn eine Unterscheidung des Druckabfalls von einer Leckagesituation vorgenommen werden soll, spielt der Außendruck als variabler Einfluss eine Rolle. In einem Leckagefall kann der Druckabfall ausschließlich auf eine Untergrenze auf Höhe des Umgebungsdrucks fallen, da dieser den Gegendruck der Umgebung an der Leckageposition darstellt. Wird ein Absolutgrenzwert verwendet, so kann als Umgebungsdruck dieser als Druckgrenzwert flexibel dem variablen Umgebungsdruck nachgeführt werden. Mit anderen Worten wird der Druckgrenzwert entweder genau oder etwas unterhalb des Umgebungsdruck zu diesem nachgeführt, sodass immer beim Unterschreiten des Druckgrenzwertes sozusagen automatisch auch ein Unterschreiten des Umgebungsdrucks vorliegt, und somit in genau einem solchen Fall eine Leckage durch das Unterschreiten des Umgebungsdrucks auszuschließen ist.

Es kann darüber hinaus von Vorteil sein, wenn bei einem erfindungsgemäßen Verfahren der überwachte Gasdruck zumindest bei Erzeugung des Kurzschluss-Fehlersignal gespeichert wird. Damit wird es möglich, solche Fehlerfälle nachzuvollziehen und nachzuverfolgen und insbesondere die erkannten elektrischen Kurzschlüsse im Nachgang zu überprüfen. Auch ist ein Einbinden in eine Betriebskontrolle möglich, um beispielsweise die Betriebssituation beim Erzeugen des Kurzschluss-Fehlersignals zu überprüfen und aufzuzeichnen, sodass in Zukunft ein elektrischer Kurzschluss in einem ähnlichen Betriebsfall möglicherweise vermeidbar ist. Mit anderen Worten erlaubt das Speichern eine Rückkopplung in die normale Betriebskontrolle des Brennstoffzellensystems.

Ein weiterer Vorteil wird dann erzielt, wenn bei einem erfindungsgemäßen Verfahren bei einem Vergleich eine Nachregelung einer Gaszufuhr berücksichtigt wird. Eine solche Nachregelung wurde weiter oben bereits angedeutet und ist insbesondere dann relevant, wenn eine hohe Regelungs- und Kontrollflexibilität in der normalen Betriebskontrolle für das Brennstoffzellensystem vorliegt. Wird bei einem elektrischen Kurzschluss kurzfristig und sprunghaft der Brennstoffverbrauch stark ansteigen, so führt dies nicht nur zu dem beschriebenen Druckanfall, sondern auch zu einer entsprechenden Nachregelung der Betriebskontrolle. Eine solche Nachregelung zu berücksichtigen, insbesondere in eine Bestimmung eines virtuellen Gasdruckes mit einzubeziehen und/oder den dazu gehörigen Druckgrenzwert anzupassen, führt dazu, dass auch bei hoher Flexibilität und damit schneller Nachregelung zum Druckausgleich ein elektrischer Kurzschluss erkannt und entsprechend das Kurzschluss-Fehlersignal auch erzeugt wird.

Vorteile kann es ebenfalls mit sich bringen, wenn bei einem erfindungsgemäßen Verfahren zusätzlich die Massenströme wenigstens eines Gases durch den Brennstoffzellenstapel bestimmt werden, wobei aus dem Gasverbrauch ein Stromwert des aus dieser Gasmenge erzeugten Stroms bestimmt und mit dem Stromgrenzwert verglichen wird. Hier wird es möglich, eine weitere Genauigkeitssteigerung zu erzielen, indem nicht nur die Drücke, sondern sogar die zu erwartenden Massenströme in den Vergleich miteinbezogen werden. Ein solcher zusätzlicher Grenzwertvergleich erlaubt es, vorzugsweise sogar für mehrere Gasströme, noch genauer und robuster die Erkennung des elektrischen Kurzschlusses an einem Brennstoffzellenstapel zu gewährleisten.

Ebenfalls Gegenstand der vorliegenden Erfindung ist ein Computerprogrammprodukt, aufweisend Befehle, welche bei der Ausführung durch einen Computer diesen veranlassen die Schritte eines erfindungsgemäßen Verfahrens durchzuführen. Damit bringt auch ein solches Computerprogrammprodukt die gleichen Vorteilte mit sich, wie sie ausführlich mit Bezug auf ein erfindungsgemäßes Verfahren erläutert worden sind.

Ein weiterer Gegenstand der vorliegenden Erfindung ist eine Erkennungsvorrichtung für eine Erkennung eines elektrischen Kurzschlusses an einem Brennstoffzellenstapel eines Brennstoffzellensystems. Eine solche Erkennungsvorrichtung zeichnet sich dadurch aus, dass ein Überwachungsmodul vorgesehen ist, zum Überwachen wenigstens eines Gasdrucks im Brennstoffzellensystem. Mit einem Vergleichsmodul erfolgt ein Vergleich des überwachten Gasdrucks mit wenigstens einem Druckgrenzwert auf einem Druckabfall. Abschließend kann ein Erzeugungsmodul ein Kurzschluss-Fehlersignal erzeugen, wenn der überwachte Gasdruck den wenigstens einen Druckgrenzwert unterschreitet. Insbesondere sind das Überwachungsmodul, das Vergleichsmodul und/oder das Erzeugungsmodul für die Durchführung eines erfindungsgemäßen Verfahrens ausgebildet. Damit bringt auch eine solche Erkennungsvorrichtung die gleichen Vorteile mit sich, wie sie ausführlich mit Bezug auf ein erfindungsgemäßes Verfahren erläutert worden sind.

Darüber hinaus ist ebenfalls Gegenstand der vorliegenden Erfindung ein Brennstoffzellensystem für eine Erzeugung von elektrischem Strom. Ein solches Brennstoffzellensystem weist einen Brennstoffzellenstapel mit einem Anodenabschnitt und einen Kathodenabschnitt auf. Der Anodenabschnitt ist mit einem Anodenzuführabschnitt für eine Zufuhr von Anodenzuführgas und einem Anodenabführabschnitt für eine Abfuhr von Anodenabgas ausgestattet. Ähnlich ist der Kathodenabschnitt mit einem Kathodenzuführabschnitt für eine Zufuhr von Kathodenzuführgas und mit einem Kathodenabführabschnitt für eine Abfuhr von Kathodenabgas ausgebildet. Darüber hinaus ist ein solches Brennstoffzellensystem mit einer erfindungsgemäßen Erkennungsvorrichtung ausgestattet für eine Erkennung eines elektrischen Kurzschlusses an dem Brennstoffzellenstapel. Damit bringt auch ein solches Brennstoffzellensystem die gleichen Vorteile mit sich, wie sie im Detail mit Bezug auf ein erfindungsgemäßes Verfahren erläutert worden sind.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Es zeigen schematisch:
- Fig. 1: eine Ausführungsform eines erfindungsgemäßen Brennstoffzellensystems,
- Fig. 2: eine Ausführungsform einer erfindungsgemäßen Erkennungsvorrichtung,
- Fig. 3: ein möglicher Verlauf eines überwachten Gasdrucks,
- Fig. 4: ein weiterer möglicher Verlauf eines überwachten Gasdrucks,
- Fig. 5: eine alternative Ausführungsform eines erfindungsgemäßen Brennstoffzellensystems,
- Fig. 6: eine alternative Ausführungsform einer erfindungsgemäßen Erkennungsvorrichtung,
- Fig. 7: ein alternativer möglicher Verlauf eines Gasdrucks,
- Fig. 8: eine Möglichkeit der Anpassung der Druckgrenzwerte und
- Fig. 9: eine alternative Ausführungsform einer erfindungsgemäßen Erkennungsvorrichtung.

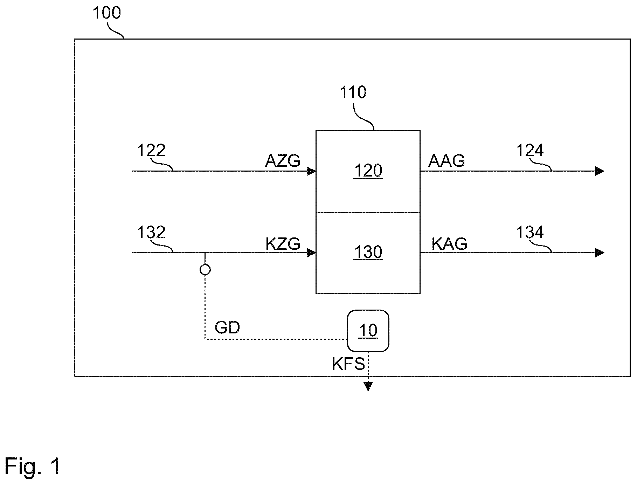

In der Figur 1 ist schematisch ein Brennstoffzellensystem 100 dargestellt. Dieses ist hier zum Beispiel mit einem einzigen Brennstoffzellenstapel 110 dargestellt, welcher schematisch aufgeteilt einen Anodenabschnitt 120 und einen Kathodenabschnitt 130 aufweist. Für den Betrieb zum Erzeugen eines elektrischen Stroms wird über den Anodenzuführabschnitt 122 Anodenzuführgas AZG dem Anodenabschnitt 120 hinzugeführt. Parallel erfolgt eine Zufuhr von Kathodenzuführgas KZG über den Kathodenzuführabschnitt 132 zum Kathodenabschnitt 130. Unter Erzeugung von elektrischer Energie erfolgt die chemische Reaktion im Brennstoffzellenstapel 110 und das entstehende Anodenabgas AAG wird über den Anodenabführabschnitt 124 abgeführt. Das ebenfalls entstehende Kathodenabgas KAG wird parallel über den Kathodenabführabschnitt 134 abgeführt.

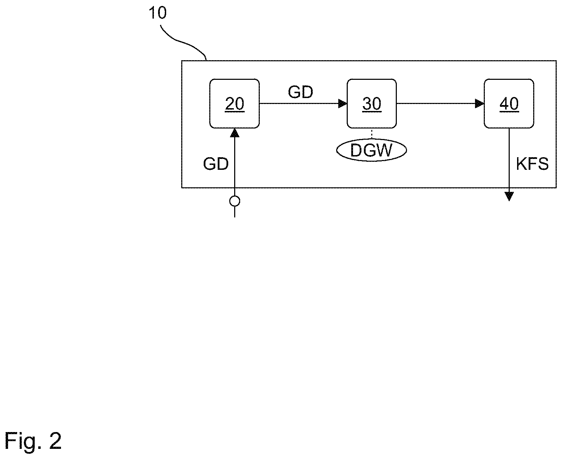

Erfindungsgemäß ist hier nun ein Erkennungsvorrichtung 10 vorgesehen, wie sie zum Beispiel in der nachfolgenden Figur 2 näher dargestellt ist. Hier ist ein einzelner Drucksensor im Kathodenzuführabschnitt 132 vorgesehen, um den dort vorhandenen Gasdruck GD zu überwachen und entsprechend in der Erkennungsvorrichtung 10 weiter zu verarbeiten. Wird ein Unterschreiten eines Druckgrenzwertes DGW erkannt, erfolgt das erfindungsgemäße Erzeugen des Kurzschluss-Fehlersignals KFS, welches dann von der Erkennungsvorrichtung 10 aus- oder weitergegeben wird.

Die Figur 2 zeigt schematisch, wie eine solche Erkennungsvorrichtung 10 gemäß der Figur 1 näher ausgestaltet sein kann. Mir Bezug auf einen einzelnen Sensor wird der Gasdruck GD im Überwachungsmodul 20 überwacht und kontinuierlich oder schrittweise an das Vergleichsmodul 30 weitergegeben. Dort können direkt oder in einer Datenbank gespeichert ein oder mehrere Druckgrenzwerte DGW vorgesehen sein, welche entsprechend mit dem einen oder mehreren Gasdrücken GD verglichen werden. Abschließend erfolgt im Erzeugungsmodul 40 bei einem Unterschreiten des Druckgrenzwerts DGW das Erzeugen und auch das Ausgeben des Kurzschluss-Fehlersignals KFS.

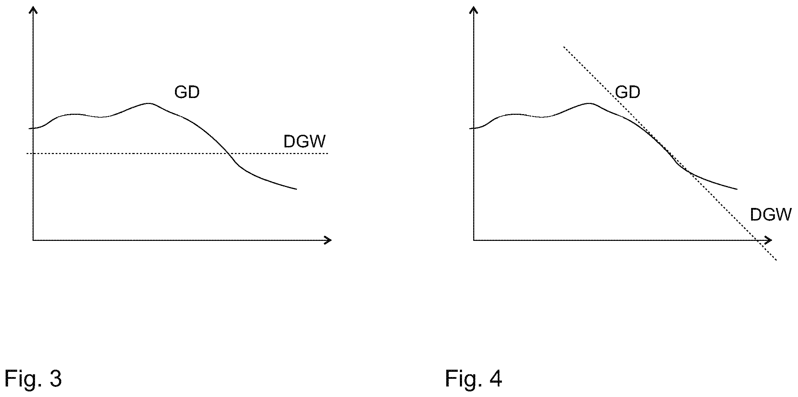

Die Figur 3 zeigt schematisch wie sich ein Gasdruck GD Werteüberwachung im Verlauf abbilden kann. Hier ist bereits ein absoluter Druckgrenzwert DGW eingezeichnet, welcher zu einem gewissen Zeitpunkt vom Gasdruck GD unterschritten wird. Dieses Unterschreiten ist bei dieser Ausführungsform nun ein Auslöser, welcher im Erzeugungsmodul 40 das Erzeugen des Kurzschluss-Fehlersignals KFS auslöst.

Die Figur 4 zeigt eine Variante, bei welcher der Druckgrenzwert DGW als Steigungsgrenzwert ausgebildet ist. Unabhängig davon, wann tatsächlich ein definierter Druckgrenzwert DGW absolut unterschritten wird, wird hier ab einem schnellen Abfall, hier mit circa 45 Grad Steigung, der Druckgrenzwert DGW als unterschritten angezeigt und entsprechend das Kurzschluss-Fehlersignal KFS erzeugt.

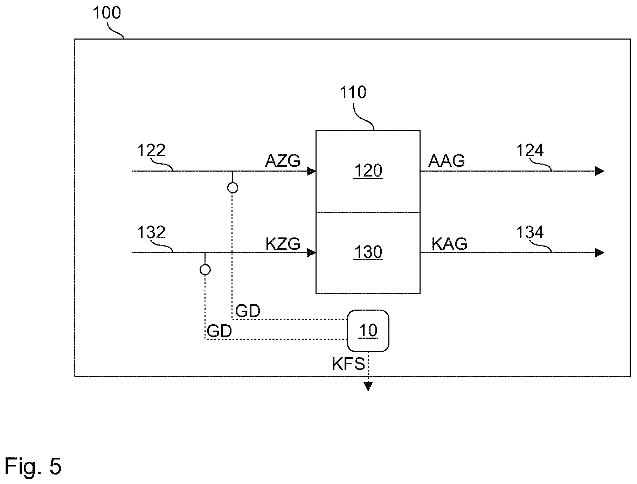

Die Figur 5 zeigt eine Weiterbildung des Brennstoffzellensystems 100, welche hier mit zwei Sensoren die Gasdrücke GD sowohl im Anodenzuführabschnitt 122 als auch im Kathodenzuführabschnitt 132 erfasst. Selbstverständlich ist auch ein Erfassen über Kreuz in den Zuführ- und Abführabschnitten oder nur in den Abführabschnitten grundsätzlich denkbar. Auch ein Erfassen aller Gasdrücke GD aller Gasführungsabschnitte im Brennstoffzellensystem 100 ist selbstverständlich ebenfalls möglich.

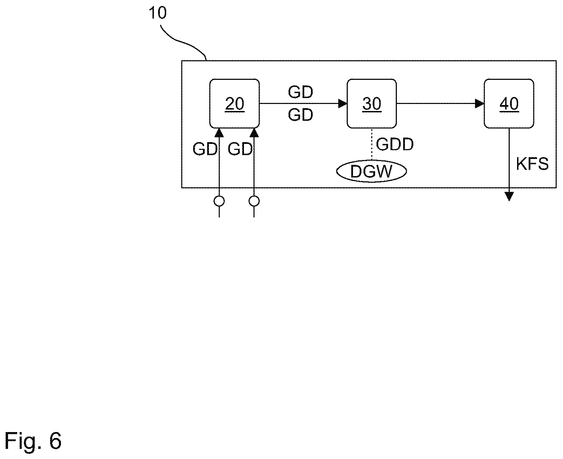

In Figur 6 ist eine auf der Figur 5 basierende Weiterbildung der Erkennungsvorrichtung 10 dargestellt, welche nun zwei Gasdrücke GD parallel erfassen und an das Vergleichsmodul 30 weitergeben kann. Bei dieser Ausführungsform erfolgt im Vergleichsmodul 30 das Ausbilden einer Gasdruckdifferenz GDD, welche entsprechend mit dem Druckgrenzwert DGW in gleicher Weise verglichen wird. Der abschließende Schritt bei Unterschreiten ist wieder identisch und erfolgt im Ausgeben des erfolgten Kurschluss-Fehlersignals KFS vom Erzeugungsmodul 40.

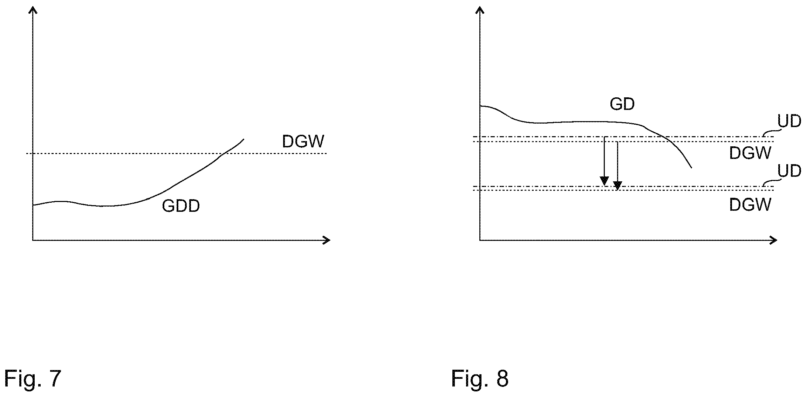

Die Figuren 7 und 8 zeigen weitere Alternativen für mögliche Gasdrücke GD. Die Figur 7 bezieht sich dabei auf die Figur 6 und den Verlauf einer Gasdruckdifferenz GDD, welche hier über die Zeit ansteigt. Eine hohe Gasdruckdifferenz GDD zeigt hier an, dass die überwachten Gasdrücke GD immer stärker voneinander abweichen, sodass hier nun ein Druckgrenzwert DGW von unten nach oben unterschritten wird.

In der Figur 8 ist ein variabler Druckgrenzwert DGW dargestellt, welcher insbesondere vom Umgebungsdruck UD abhängt. Sinkt der Umgebungsdruck UD gemäß der Pfeildarstellung ab, wird der Druckgrenzwert DGW um den gleichen Wert nachgeführt, sodass er knapp unterhalb des Umgebungsdruck UD liegt. Bei der dargestellten Situation in der Figur 8 würde bei dem niedrigen Umgebungsdruck UD entsprechend kein Kurzschluss-Fehlersignal KFS erzeugt, während bei dem hohen Umgebungsdruck UD genau das der Fall wäre. Die Robustheit der Erkennung wird auf dieses Weise noch weiter gesteigert, insbesondere hinsichtlich der Unterscheidung von Gasleckagen.

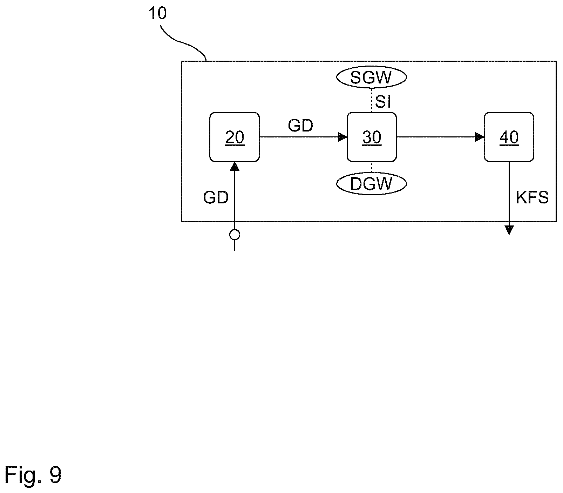

Auch die Figur 9 zeigt eine Verbesserung der Robustheit eines solchem Erkennungsverfahrens, indem in der Erkennungsvorrichtung 10 nun zusätzlich noch ein Stromwert SI mit einem Stromgrenzwert SGW verglichen wird. Auch dies erzeugt nun eine doppelte Absicherung, sodass nur beim Unterschreiten von Druckgrenzwerten DGW und Stromgrenzwert SGW im gemeinsamen Unterschreiten sozusagen das Kurzschluss-Fehlersignal KFS von dem Erzeugungsmodul 40 erzeugt und ausgegeben wird.

Die voranstehende Erläuterung der Ausführungsformen beschreibt die vorliegende Erfindung ausschließlich im Rahmen von Beispielen.

### Bezugszeichenliste

- 10: Erkennungsvorrichtung
- 20: Überwachungsmodul
- 30: Vergleichsmodul
- 40: Erzeugungsmodul

- 100: Brennstoffzellensystem
- 110: Brennstoffzellenstapel
- 120: Anodenabschnitt
- 122: Anodenzuführabschnitt
- 124: Anodenabführabschnitt
- 130: Kathodenabschnitt
- 132: Kathodenzuführabschnitt
- 134: Kathodenabführabschnitt

- UD: Umgebungsdruck
- SI: Stromwert
- GD: Gasdruck
- GDD: Gasdruckdifferenz
- DGW: Druckgrenzwert
- SGW: Stromgrenzwert
- KFS: Kurzschluss-Fehlersignal
- AZG: Anodenzuführgas
- AAG: Anodenabgas
- KZG: Kathodenzuführgas
- KAG: Kathodenabgas

## Patentansprüche

1. Verfahren zur Erkennung eines elektrischen Kurzschlusses an einem Brennstoffzellenstapel (110) eines Brennstoffzellensystems (120), **gekennzeichnet durch** die folgenden Schritte:
- Überwachen wenigstens eines Gasdrucks (GD) im Brennstoffzellensystem (100),
- Vergleich des überwachten Gasdrucks (GD) mit wenigstens einem Druckgrenzwert (DGW) auf einen Druckabfall,
- Erzeugen eines Kurzschluss-Fehlersignals (KFS), wenn der überwachte Gasdruck (GD) den wenigstens einen Druckgrenzwert (DGW) unterschreitet.

2. Verfahren nach einem der vorangegangenen Ansprüche, **dadurch gekennzeichnet, dass** der Gasdruck (GD) wenigstens einer der folgenden Gase überwacht wird:
- Anodenzuführgas (AZG) in einem Anodenzuführabschnitt (122)
- Anodenabgas (AAG) in einem Anodenabführabschnitt (124)
- Kathodenzuführgas (KZG) in einem Kathodenzuführabschnitt (132)
- Kathodenabführgas (KAG) in einem Kathodenabführabschnitt (134)

3. Verfahren nach einem der vorangegangenen Ansprüche, **dadurch gekennzeichnet, dass** wenigstens zwei Gasdrücke (GD) überwacht werden, wobei ein Gasdruck (GD) auf der Seite eines Anodenabschnitts (120) und ein Gasdruck (GD) auf der Seite eines Kathodenabschnitts (130) des Brennstoffzellenstapels (110) überwacht wird.

4. Verfahren nach Anspruch 3, **dadurch gekennzeichnet, dass** für jeden überwachten Gasdruck (GD) ein spezifischer Druckgrenzwert (DGW) für den Vergleich verwendet wird.

5. Verfahren nach einem der Ansprüche 3 oder 4, **dadurch gekennzeichnet, dass** aus den überwachten Gasdrücken (GD) die Gasdruckdifferenz (GDD) bestimmt wird und diese mit dem Druckgrenzwert (DGW) verglichen wird.

6. Verfahren nach einem der vorangegangenen Ansprüche, **dadurch gekennzeichnet, dass** der Druckgrenzwert (DGW) zumindest teilweise als absoluter Absolutgrenzwert ausgebildet ist.

7. Verfahren nach einem der vorangegangenen Ansprüche, **dadurch gekennzeichnet, dass** der Druckgrenzwert (DGW) zumindest teilweise als Steigungsgrenzwert ausgebildet ist.

8. Verfahren nach einem der vorangegangenen Ansprüche, **dadurch gekennzeichnet, dass** der Druckgrenzwert (DGW) variabel ausgebildet ist, insbesondere als Absolutgrenzwert vom Umgebungsdruck (UD) abhängt.

9. Verfahren nach einem der vorangegangenen Ansprüche, **dadurch gekennzeichnet, dass** der überwachte Gasdruck (GD) zumindest bei Erzeugung des Kurzschluss-Fehlersignals (KFS) gespeichert wird.

10. Verfahren nach einem der vorangegangenen Ansprüche, **dadurch gekennzeichnet, dass** beim Vergleich eine Nachregelung einer Gaszufuhr berücksichtigt wird.

11. Verfahren nach einem der vorangegangenen Ansprüche, **dadurch gekennzeichnet, dass** zusätzlich die Massenströme wenigstens eines Gases durch den Brennstoffzellenstapel (110) bestimmt werden, wobei aus dem Gasverbrauch ein Stromwert (GI) des aus dieser Gasmenge erzeugten Stroms bestimmt und mit einem Stromgrenzwert (SGW) verglichen wird.

12. Computerprogramprodukt, aufweisend Befehle, welche bei der Ausführung durch einen Computer diesen veranlassen die Schritte eines Verfahrens mit den Merkmalen eines der Ansprüche 1 bis 11 auszuführen.

13. Erkennungsvorrichtung (10) für eine Erkennung eines elektrischen Kurzschlusses an einem Brennstoffzellenstapel (110) eines Brennstoffzellensystems (100), **gekennzeichnet durch** ein Überwachungsmodul (20) zum Überwachen wenigstens eines Gasdrucks (GD) im Brennstoffzellensystem (100), ein Vergleichsmodul (30) zum Vergleich des überwachten Gasdrucks (GD) mit wenigstens einem Druckgrenzwert (DGW) auf einen Druckabfall und ein Erzeugungsmodul (40) für ein Erzeugen eines Kurzschluss-Fehlersignals (KFS), wenn der überwachte Gasdruck (GD) den wenigstens einen Druckgrenzwert (DGW) unterschreitet, wobei das Überwachungsmodul (20), das Vergleichsmodul (30) und/oder das Erzeugungsmodul (40) für eine Ausführung eines Verfahrens mit den Merkmalen eines der Ansprüche 1 bis 11 ausgebildet sind.

14. Brennstoffzellensystem (100) für eine Erzeugung von elektrischem Strom, aufweisend einen Brennstoffzellenstapel (110) mit einem Anodenabschnitt (120) und einem Kathodenabschnitt (130), der Anodenabschnitt (120) aufweisend einen Anodenzuführabschnitt (122) für eine Zufuhr von Anodenzuführgas (AZG) und einen Anodenabführabschnitt (124) für eine Abfuhr von Anodenabgas (AAG), der Kathodenabschnitt (130) aufweisend einen Kathodenzuführabschnitt (132) für eine Zufuhr von Kathodenzuführgas (KZG) und einen Kathodenabführabschnitt (134) für eine Abfuhr von Kathodenabgas (KAG), **dadurch gekennzeichnet, dass** eine Erkennungsvorrichtung (10) mit den Merkmalen des Anspruchs 13 für Erkennung eines elektrischen Kurzschlusses an dem Brennstoffzellenstapel (110) vorgesehen ist.

## Claims

1. A method for detecting an electrical short circuit in a fuel cell stack (110) of a fuel cell system (120), **characterized by** the following steps:
- monitoring at least one gas pressure (GD) in the fuel cell system (100),
- comparing the monitored gas pressure (GD) with at least one pressure limit value (DGW) for a pressure drop,
- generating a short-circuit fault signal (KFS) if the monitored gas pressure (GD) falls below the at least one pressure limit value (DGW).

2. Method according to one of the preceding claims, **characterized in that** the gas pressure (GD) of at least one of the following gases is monitored:
- anode supply gas (AZG) in an anode supply section (122)
- anode exhaust gas (AAG) in an anode discharge section (124)
- cathode supply gas (KZG) in a cathode supply section (132)
- cathode discharge gas (KAG) in a cathode discharge section (134).

3. Method according to one of the preceding claims, **characterized in that** at least two gas pressures (GD) are monitored, wherein a gas pressure (GD) on the side of an anode section (120) and a gas pressure (GD) on the side of a cathode section (130) of the fuel cell stack (110) are monitored.

4. Method according to claim 3, **characterized in that** for each monitored gas pressure (GD) a specific pressure limit value (DGW) is used for the comparison.

5. Method according to one of claims 3 or 4, **characterized in that** the gas pressure difference (GDD) is determined from the monitored gas pressures (GD) and is compared with the pressure limit value (DGW).

6. Method according to one of the preceding claims, **characterized in that** the pressure limit value (DGW) is at least partially designed as an absolute limit value.

7. Method according to one of the preceding claims, **characterized in that** the pressure limit value (DGW) is at least partially designed as a gradient limit value.

8. Method according to one of the preceding claims, **characterized in that** the pressure limit value (DGW) is variable, in particular as an absolute limit value dependent on the ambient pressure (UD).

9. Method according to one of the preceding claims, **characterized in that** the monitored gas pressure (GD) is stored at least upon generation of the short-circuit fault signal (KFS).

10. Method according to one of the preceding claims, **characterized in that** a readjustment of a gas supply is taken into account in the comparison.

11. Method according to one of the preceding claims, **characterized in that** the mass flows of at least one gas through the fuel cell stack (110) are additionally determined, wherein a current value (GI) of the current generated from this gas quantity is determined from the gas consumption and compared with a current limit value (SGW).

12. A computer program product comprising instructions which, when executed by a computer, cause the computer to perform the steps of a method having the features of any of claims 1 to 11.

13. A detection device (10) for detecting an electrical short circuit in a fuel cell stack (110) of a fuel cell system (100), **characterized by** a monitoring module (20) for monitoring at least one gas pressure (GD) in the fuel cell system (100), a comparison module (30) for comparing the monitored gas pressure (GD) with at least one pressure limit value (DGW) for a pressure drop, and a generation module (40) for generating a short-circuit error signal (KFS) when the monitored gas pressure (GD) falls below the at least one pressure limit value (DGW), wherein the monitoring module (20), the comparison module (30), and/or the generation module (40) are configured for executing a method having the features of one of claims 1 to 11.

14. A fuel cell system (100) for generating electrical power, comprising a fuel cell stack (110) with an anode section (120) and a cathode section (130), the anode section (120) comprising an anode supply section (122) for supplying anode supply gas (AZG) and an anode discharge section (124) for discharging anode exhaust gas (AAG), the cathode section (130) comprising a cathode supply section (132) for supplying cathode supply gas (KZG) and a cathode discharge section (134) for discharging cathode exhaust gas (KAG), **characterized in that** a detection device (10) with the features of claim 13 for detecting an electrical short circuit on the fuel cell stack (110).

## Revendications

1. Procédé de détection d'un court-circuit électrique dans un empilement de piles à combustible (110) d'un système de piles à combustible (120), **caractérisé par** les étapes suivantes :
- surveillance d'au moins une pression de gaz (GD) dans le système de piles à combustible (100),
- comparaison de la pression de gaz (GD) surveillée avec au moins une valeur limite de pression (DGW) pour détecter une chute de pression,
- génération d'un signal de court-circuit (KFS) si la pression de gaz (GD) surveillée descend en dessous de la ou des valeurs limites de pression (DGW).

2. Procédé selon l'une des revendications précédentes, **caractérisé en ce que** la pression de gaz (GD) d'au moins un des gaz suivants est surveillée :
- gaz d'alimentation anodique (AZG) dans une section d'alimentation anodique (122)
- gaz d'échappement anodique (AAG) dans une section de décharge anodique (124)
- gaz d'alimentation cathodique (KZG) dans une section d'alimentation cathodique (132)
- gaz de décharge cathodique (KAG) dans une section de décharge cathodique (134)

3. Procédé selon l'une des revendications précédentes, **caractérisé en ce qu'**au moins deux pressions de gaz (GD) sont surveillées, une pression de gaz (GD) côté anode (120) et une pression de gaz (GD) côté cathode (130) de la pile à combustible (110) étant surveillées.

4. Procédé selon la revendication 3, **caractérisé en ce que** pour chaque pression de gaz surveillée (GD), une valeur limite de pression spécifique (DGW) est utilisée pour la comparaison.

5. Procédé selon l'une des revendications 3 ou 4, **caractérisé en ce que** la différence de pression de gaz (GDD) est déterminée à partir des pressions de gaz surveillées (GD) et comparée à la valeur limite de pression (DGW).

6. Procédé selon l'une des revendications précédentes, **caractérisé en ce que** la valeur limite de pression (DGW) est au moins partiellement conçue comme une valeur limite absolue.

7. Procédé selon l'une des revendications précédentes, **caractérisé en ce que** la valeur limite de pression (DGW) est au moins partiellement conçue comme une valeur limite de gradient.

8. Procédé selon l'une des revendications précédentes, **caractérisé en ce que** la valeur limite de pression (DGW) est variable, notamment en tant que valeur limite absolue dépendant de la pression ambiante (UD).

9. Procédé selon l'une des revendications précédentes, **caractérisé en ce que** la pression de gaz surveillée (GD) est mémorisée au moins lors de la génération du signal de défaut de court-circuit (KFS).

10. Procédé selon l'une des revendications précédentes, **caractérisé en ce qu'**un réajustement d'une alimentation en gaz est pris en compte dans la comparaison.

11. Procédé selon l'une des revendications précédentes, **caractérisé en ce que** les flux massiques d'au moins un gaz à travers la pile à combustible (110) sont en outre déterminés, une valeur de courant (GI) du courant généré à partir de cette quantité de gaz étant déterminée à partir de la consommation de gaz et comparée à une valeur limite de courant (SGW).

12. Produit de programme informatique comprenant des instructions qui, lorsqu'elles sont exécutées par un ordinateur, amènent l'ordinateur à exécuter les étapes d'un procédé ayant les caractéristiques de l'une quelconque des revendications 1 à 11.

13. Dispositif de détection (10) pour détecter un court-circuit électrique dans un empilement de piles à combustible (110) d'un système de piles à combustible (100), **caractérisé par** un module de surveillance (20) pour surveiller au moins une pression de gaz (GD) dans le système de piles à combustible (100), un module de comparaison (30) pour comparer la pression de gaz surveillée (GD) avec au moins une valeur limite de pression (DGW) pour une chute de pression, et un module de génération (40) pour générer un signal d'erreur de court-circuit (KFS) lorsque la pression de gaz surveillée (GD) descend en dessous de la ou des valeurs limites de pression (DGW). Le module de surveillance (20), le module de comparaison (30) et/ou le module de génération (40) sont configurés pour mettre en œuvre un procédé selon l'une des revendications 1 à 11.

14. Système de pile à combustible (100) pour la production d'énergie électrique, comprenant un empilement de piles à combustible (110) doté d'une section anodique (120) et d'une section cathodique (130). La section anodique (120) comprend une section d'alimentation anodique (122) pour l'alimentation en gaz anodique (AZG) et une section de décharge anodique (124) pour l'évacuation des gaz d'échappement anodique (AAG). La section cathodique (130) comprend une section d'alimentation cathodique (132) pour l'alimentation en gaz cathodique (KZG) et une section de décharge cathodique (134) pour l'évacuation des gaz d'échappement cathodiques (KAG). **Caractérisé en ce qu'**un dispositif de détection (10) présentant les caractéristiques de la revendication 13 détecte un court-circuit électrique sur l'empilement de piles à combustible (110).
